# EUROPEAN PATENT APPLICATION

(11) **EP 2 868 896 A1**
(43) Date of publication of application: **06.05.2015**
(21) Application number: 13191651.2
(22) Date of filing: 05.11.2013
(51) Int. Cl.: F02C 7/00, B64D 41/00, H01L 35/00

(54) **Turbo engine with an energy harvesting device, energy harvesting device and a method for energy harvesting**

(71) Applicant: Rolls-Royce Deutschland Ltd & Co KG, 15827 Blankenfelde-Mahlow (DE)
(72) Inventor: Elgezabal Gomez, Oroitz, 12105 Berlin (DE)
(74) Representative: Emig, Ralf

(57) **Abstract**

Turbo engine, in particular a turbine for an airplane, characterized in that the turbo engine (100) is coupled with an energy harvesting device (30) comprising at least one thermoelectric device (10) for producing electric energy from temperature differences in the turbo engine (100) and / or at least one kinetic energy converter (40) for the conversion of vibrational energy into electric energy and wherein the energy harvesting device (30) is coupled to a control system (20) of the turbo engine (100) as a redundant electric energy supply and / or the at least one kinetic energy converter (40) providing a means for reducing the vibrational energy of the turbo engine (100). The invention also relates to an energy harvesting device and a method for energy harvesting.

## Description

The invention refers to a turbo engine with an energy harvesting device according to claim 1, an energy harvesting device in a turbine according to claim 9 and a method for energy harvesting according to claim 12.

Turbo engines, such e.g. turbo engines in civil airplanes, comprise more and more control systems to handle e.g. complex safety and operational parameters. For coping with the increase of power consumption associated to the bigger number of electronic devices, some technological solutions have been developed. From e.g. US 2012 / 0031067 A1 it is known to use thermoelectric elements in the generation of electrical energy to power electrical components making them standalone, thus alleviating the electrical load of the engine power generator.

Although, effective from the energetic point of view, the use of standalone electronic components for safety-critical applications is not acceptable due to safety concerns. Electronic systems associated to safety-critical applications are required to fulfill stringent availability and safety requirements in order to avoid that a fault results in an event with catastrophic consequences and / or casualties. In order to fulfill its availability and safety requirements the electronic systems are designed in a redundant way, in which the same function is performed by several systems, thus assuring that in case a part of the system fails, its function will still be delivered by the remaining redundant part. Even if this approach is robust, redundant systems based on similar technologies are still prone to a simultaneous fault which will affect all the redundant parts in the same way. The so-called common-mode fault can be avoided by the implementation of dissimilar redundancy which consists of delivering the same function by means of different system architectures or technological foundations.

By having a turbo engine, in particular a turbine for an airplane, coupled with an energy harvesting device comprising at least one thermoelectric device for producing electric energy from temperature differences in the turbo engine and / or at least one kinetic energy converter for the conversion of vibrational energy into electric energy and wherein the energy harvesting device is coupled to a control system of the turbo engine as a redundant electric energy supply, the turbo engine becomes more robust. Alternatively or in addition the at least one kinetic energy converter provides a means for reducing the vibrational energy of the turbo engine. The electric energy generated by the kinetic converter can, but does not have to be used to feed a redundant electric energy supply. This means also makes the turbo engine more robust, since the mechanical loads are reduced, be the absorption of vibrational energy through the at least one kinetic energy converter.

The energy harvesting system constitutes a dedicated dissimilar power source for the components of the engine controls system which is separated from the main electrical power supply system.

For an efficient use of temperature differentials and / or vibrational energy it is advantageous to position the energy harvesting device with the at least one thermoelectric device and / or at least one kinetic energy converter for the conversion of vibrational energy into electric energy and at least partially on the core of the turbo engine, in particular around the compressor, the combustion chamber and / or the turbine. The kinetic energy converter can be used to dissipate vibrational energy.

In another embodiment the at least one kinetic energy converter comprises a magnetic device which is coupled with a conducting element, so that a relative movement of the magnetic device to the conducting element introduces a voltage in the conducting element. In addition or alternatively the kinetic energy converter comprises a piezoelectric element.

For an effective packaging of the energy harvesting device a further embodiment has a layered structure with at least one thermoelectric device layer and / or at least one kinetic converter layer. In a particularly advantageous embodiment the energy harvesting device is at least partially a flexible structure to fit around round or complex shapes in the turbine engine.

In one embodiment the current coming from the at least one thermoelectric device is converted into an alternating current or the current coming from the at least one kinetic energy converter is converted into direct current. This provides the current in the turbine engine in the appropriate form.

It is also advantageous that at least one thermoelectric device and / or the at least one kinetic energy converter is coupled to an electrical energy storage means, in particular a rechargeable battery and / or a capacitor.

The problem is also solved by an energy harvesting device according to claim 9 for the use in a turbo engine, in particular a turbine for an airplane, where the energy harvesting device comprises at least one thermoelectric device for producing electric energy from temperature differences in the operating turbo device and / or at least one kinetic energy converter for the conversion of vibrational energy into electric energy and wherein the energy harvesting device can be coupled to a control system of the turbo device as a redundant electric energy supply.

In one embodiment of the energy harvesting device it comprises at least one kinetic energy converter for the conversion of vibrational energy into electric energy to be used as a further redundant electric energy supply for the control system of the turbo device.

A further embodiment of the energy harvesting device comprises a layered structure with at least one thermoelectric device layer and / or at least one kinetic converter layer and in particular having a flexible structure to fit around round or complex shapes in the turbine engine.

The problem is also solved by the method with the features of claim 12.

Embodiments of the invention are described in an exemplary way in connection with the following figures.
Fig. 1 showing an embodiment of a turbine engine with a region in which an energy harvesting device with thermoelectric elements is situated;
Fig. 2 schematic cross section of an embodiment of a thermoelectric device;
Fig. 3 schematic view of an embodiment of an array of thermoelectric devices;
Fig. 4 schematic view of a first embodiment of an energy harvesting device;
Fig. 5 cross section along line A-A in Fig. 4;
Fig. 6 cross section along line B-B in Fig. 5.
Fig. 7 schematic view of a first embodiment of a kinetic energy converter;
Fig. 8 schematic view of a second embodiment of a kinetic energy converter;
Fig. 9 schematic perspective view of a second embodiment of an energy harvesting device;
Fig. 10 cross section along line A-A in Fig. 9.

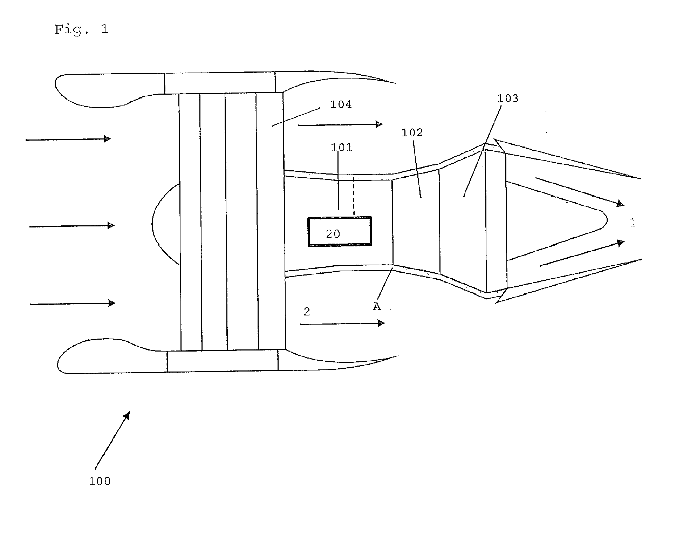

In Fig. 1 a schematic cross section of a known aircraft turbofan engine 100 is shown as an example of a turbo engine. In operation air is entering the turbofan engine 100 from the left as intake air. In the right hand side the air is leaving the turbo engine 100 in two separate streams.

The first stream is compressed by a compressor 101, heated in a combustion chamber 102 and exits the turbofan engine 100 as a relatively hot, high pressure and high velocity exhaust stream 1. A turbine 103 at the end of the engine core is driving the turbo-fan stage 104 at the entrance of the turbofan engine 100. The turbo-fan stage 104 accelerates the second stream 2; the bypass stream. The bypass stream 2 is less compressed than the first stream 101 and cooler.

Therefore, different parts of the turbofan engine 100 are subject to different temperatures. The core (i.e. the compressor 101, the combustion chamber 102, the turbine 103) of the turbofan engine 100 is generally hotter than the other parts of the turbofan engine 100.

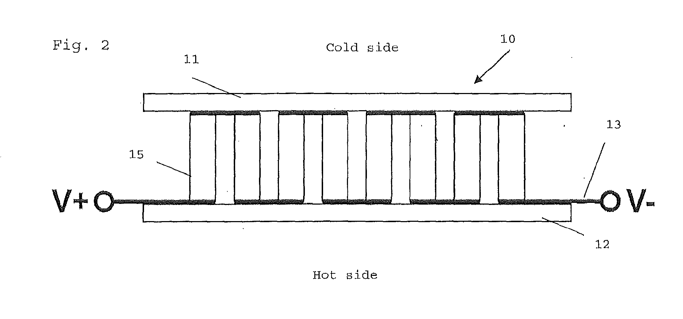

Thermoelectric devices 10 (see Fig. 2) known in the art use the e.g. the Seebeck effect as means for the conversion of differences into electric voltage. The thermoelectric device 2 creates voltage when there is a different temperature on opposite sides.

In Fig. 1 a thermoelectric conversion region A is shown at the outside of the core of the turbofan engine 100. It extends axially from the compressor 101 to the combustion chamber 102 and to the turbine 103. Radially - on the inner side - the thermoelectric conversion region A is subjected to relatively high temperatures from the core. On the outside the thermoelectric conversion region A is subjected to relatively low temperatures due to the bypass stream 2 flowing over it. The temperature differential between the core of the turbine engine 100 and the free flowing bypass stream 2 can be in the range of 500 to 700 K. The voltage generated by thermoelectric devices 10 is used as a redundant source of energy for a control system 20 of the turbofan engine 100. In Fig. 1 the control system 20 and its coupling with the thermoelectric conversion region A are only shown schematically since it is generally distributed throughout the turbofan engine 100.

The power generated by the thermoelectric devices is used for powering the components of the engine control system as a supplementary power source. The power generated by the thermoelectric devices is provided separately to the engine control system, thus making the system independent to common-cause faults which would eliminate the redundancy in the power supply provided by the traditional systems. Besides, in the case of a failure impacting an area of the engine, the distributed nature of the energy harvesting system would avoid the effects of a complete loss of power supply as in the way it would happen with the current power generating systems. Even if in a degraded way, the energy harvesting system would continue delivering power, thus providing graceful degradation characteristics to the power supply system.

It should be noted that the turbofan engine 100 shown in Fig. 1 is just an example for a turbo engine which has cooler and hotter regions. Therefore, the thermoelectric conversion region A might be differently formed; the principle itself would remain unchanged. The thermoelectric conversion region A is situated to exploit temperature differentials within the turbo engine 100 and / or its parts. Furthermore, the turbine engine 100 could also be a stationary gas turbine rather than an aircraft turbine.

In Fig. 2 an embodiment of a thermoelectric device 10 is schematically shown in a cross section, comprising eight thermoelectric elements 15. Each of the thermoelectric elements 15 is made from thermoelectric material, i.e. material which shows the Seebeck effect. For instance the pairing of iron and constantan has a Seebeck coefficient of 51 µV /K. Semiconductor materials such as Bismuth Telluride have higher Seebeck coefficients but are limited by their relatively low melting point.

The thermoelectric elements 15 are covered on the upper and lower side by thermal contact plates 11, 12 (preferably made from metal) which make contact with a hot side (e.g. the core area of a turbo engine) and the cold side (e.g. the area in contact with the bypass stream 2 in a turbo engine). The electrical conductor 13 is connecting the thermoelectric elements 15 in series so that the complete thermoelectric device can deliver the sum of the voltages generated over each thermoelectric element 15.

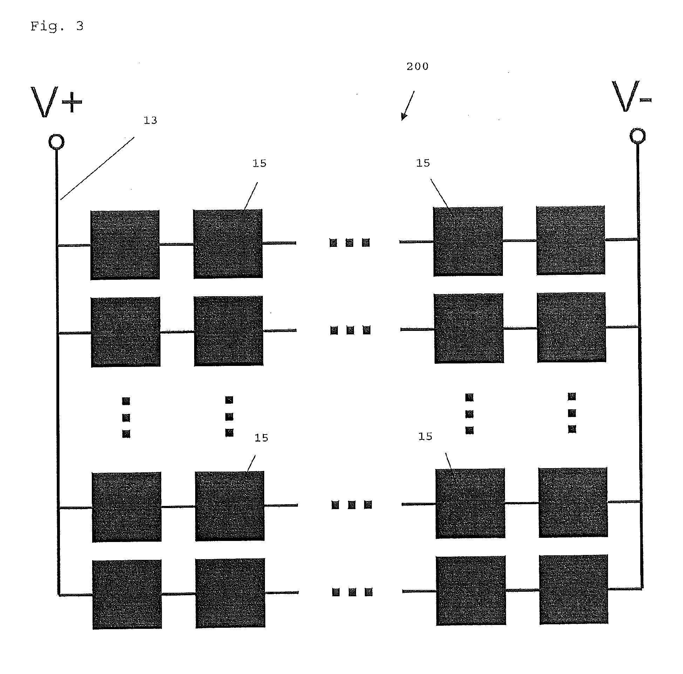

As shown in the top view of Fig. 3 thermoelectric elements 15 like the one shown in Fig. 2 can be combined into an array structure 200 by electrical conductors 13; here resulting a regular matrix-like array with identical thermoelectric devices 15. In principle, it is also possible to use an array structure 200 is not as regular as shown in Fig. 3. The thermoelectric devices 15 within the array structure 200 could be designed (e.g. size, material etc.) to the particular heat structure of the turbo engine 100. It is also possible to design the array structure 200 so that it is not a regular grid. In this way the distribution, the size and the materials of the thermoelectric devices 15 in the array structure 200 can be adjusted to the heat pattern of the turbo engine 100.

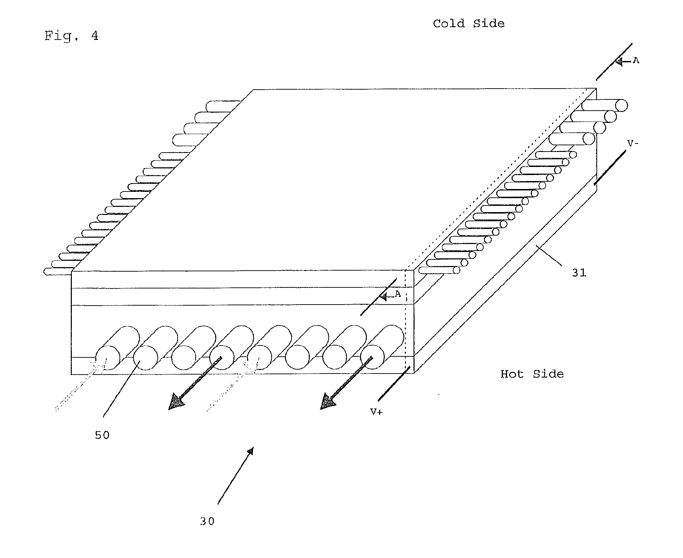

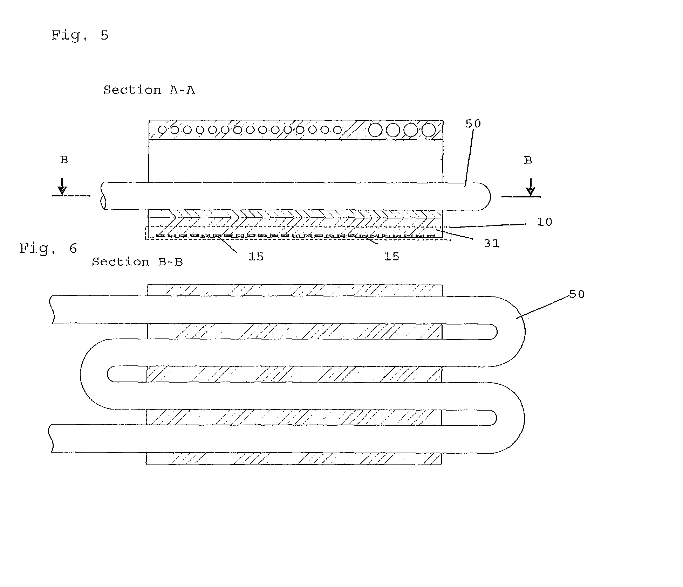

In Fig. 4 a part of an energy harvesting device 30 is shown which comprises a thermoelectric layer 31 with thermoelectric elements 15 (see Fig. 3). The layer 31 can e.g. comprise an array structure 200 with thermoelectric elements as shown in Fig. 3. In this case a plurality of thermoelectric elements 15 forms a thermoelectric device 10, indicated by the box in Fig. 5. In Fig. 5 the cross section A-A shown in Fig. 4 is depicted. Fig. 6 shows a section along the plane B-B indicated in Fig. 5.

The energy harvesting device 30 has a hot side on the lower side and a cold side on the upper side. The temperature difference between the hot and cold side is used to generate a voltage which is then used to generate redundant energy for the control system 20 (see Fig. 1).

The energy harvesting device 30 can be part of a flexible structure which can be wrapped around the core of the turbo engine 100 or at least a part of the turbo engine 100 (e.g. the thermoelectric conversion region A). With such a device it is possible to add the energy harvesting device 30 to an already existing turbo engine 100, e.g. in a revamp process.

In Fig. 4, 5 and 6 a heat pipe is 50 is shown which sort of meanders through the body of the harvesting device 30. The heat pipe 50 contains a heat-transport fluid which flows through that heat pile as indicated by the arrows. The heat-transport fluid is heated by the hot side of the energy harvesting device 30 and transports that heat energy away from the energy harvesting device 30.

Fig. 4 and 5 also show electric wiring e.g. for the FADEC system which is closer to the cold side of the energy harvesting device 30.

The heat pipe 50 fulfills different functions. First it provides a cold side to the thermoelectric elements. Furthermore, it collects the thermal energy otherwise wasted by the engine and transports it to another place where it can be used appropriately. And it removes an amount of thermal energy in another direction therefore the amount of thermal energy that must be dissipated by the structure decreases. The amount of energy that can be acquired by the heat pipe 50 should be calculated for weight and cost trade-off analysis.

In the embodiments shown so far, thermoelectric devices 10 were the sole means in the redundant supply of energy for the control system 20.

So far energy harvesting devices 30 were described in the context of thermoelectric device 10. In addition or alternatively the energy harvesting devices can also comprise kinetic energy converter 40.

It is possible to generate additional energy by tapping into the vibrational energy which is present in a turbo engine 100. The vibrations in the turbo engine 100 are a form of kinetic energy which can be harvested just like the thermoelectric energy discussed above.

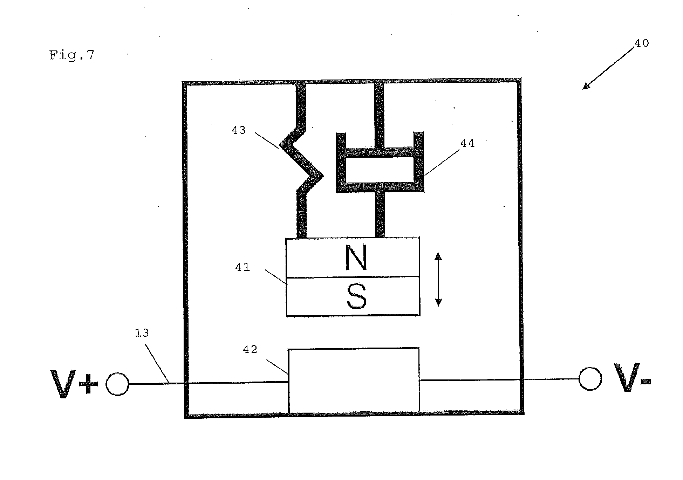

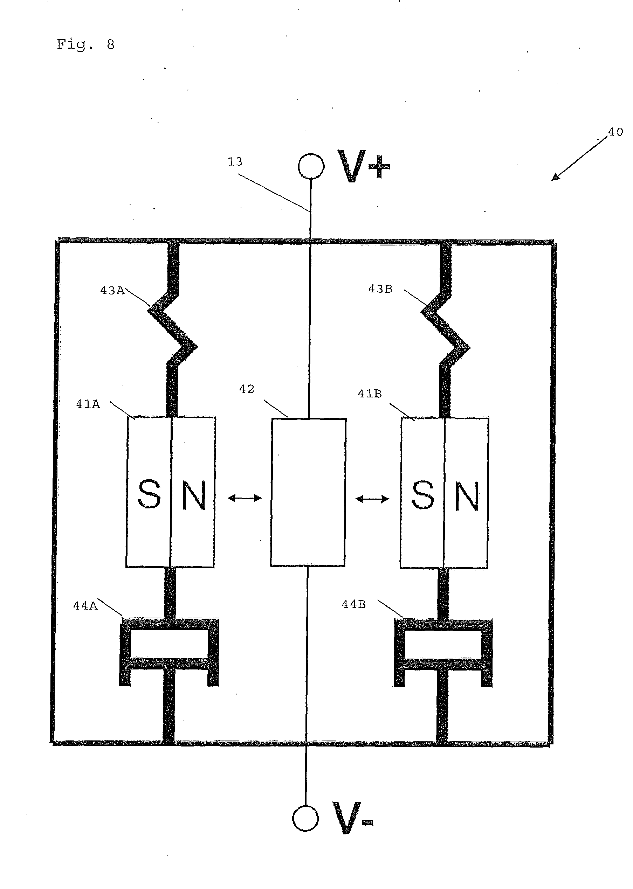

In Figs. 7 and 8 the functional principles of an embodiment of a kinetic energy converter 40 are described.

In Fig. 7 a first embodiment of a kinetic energy converter 40 is shown. A magnetic device 41 is moveably connected to a spring element 43 and a damping element 44 so that the magnetic device can oscillate in the direction indicated by the arrow in Fig. 7. If this kinetic energy converter 40 is positioned in a turbo engine 100 subject to vibrations, the oscillation frequency and amplitude of the magnetic device 41 depend on the frequency and amplitude of the vibrations in the turbo engine 100.

When the magnetic device 41 oscillates as indicated in Fig. 7 a voltage is induced in the conducting element 42. This results in a voltage which can be harvested to provide further redundant energy for the control system 200 of the turbo engine.

By converting vibrational energy into electric energy the mechanical stress on the turbo engine 100 is reduced. If only kinetic energy converters 40 are used in an energy harvesting device this alone provides some beneficial effect. The electric energy generated by the kinetic energy converter can e.g. be used in a redundant energy supply.

In Fig. 8 a second embodiment of a kinetic energy converter 40 is shown. The basic principle - generation of electric energy induced by a mechanical and magnetic oscillator - is the same as in the first embodiment shown in Fig. 7. Here, two magnetic oscillators, the magnetic devices 41 A, 41 B, are both coupled to spring elements 43A, 43B and damping elements 44A, 44B. The oscillation of the magnetic devices 41 A, 41 B is indicated by arrows in Fig. 8. The oscillation of the magnetic device 41 A, 41 B is roughly perpendicular to their connection with the spring elements 43A, 43B and the damping elements 44A, 44B.

With this oscillation a voltage is induced in the conducting element 42.

In the two embodiments shown above, the magnetic device 41 is movable relative to the conducting element 42. In principle it is possible that the magnetic device 41 and the conducting element 42 are movable relative to each other to induce an electric voltage.

In principle it is also possible to build kinetic energy converters 40 comprising piezoelectric elements.

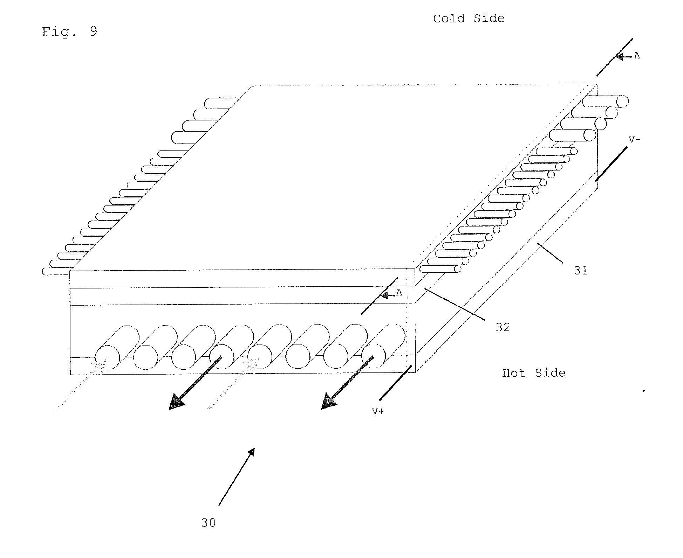

In Fig. 9 a modification of the energy harvesting device 30 described in connection with Fig. 4 is shown.

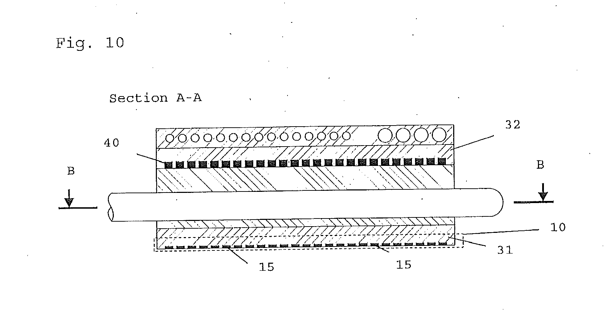

In addition to the already described thermoelectric layer 31, a kinetic energy converter layer 32 with kinetic energy converters 40 is used to pick up vibrational energy from the turbine engine 100. Fig. 10 shows the cross section A-A of Fig. 9. Here the kinetic energy harvesting layer 32 comprises several kinetic energy converters 40.

### Reference list

- 1: exhaust stream
- 2: bypass stream

- 10: thermoelectric device
- 11: first thermal contact plate
- 12: second thermal contact plate
- 13: electrical conductor
- 15: thermoelectric element

- 20: control system

- 30: energy harvesting device
- 31: thermoelectric device layer
- 32: kinetic converter layer

- 40: kinetic energy converter
- 41, 41A, 41B: magnetic device
- 42: conducting element
- 43, 43A, 43B: spring element
- 44, 44A, 44B: damping element

- 50: heat pipe
- 51: wiring

- 100: turbo engine, turbofan engine
- 101: compressor
- 102: combustion chamber
- 103: turbine
- 104: turbofan stage

- 200: array structure

- A: thermoelectric conversion region

## Claims

1. Turbo engine, in particular a turbine for an airplane,
**characterized in that**
the turbo engine (100) is coupled with an energy harvesting device (30) comprising
at least one thermoelectric device (10) for producing electric energy from temperature differences in the turbo engine (100) and / or
at least one kinetic energy converter (40) for the conversion of vibrational energy into electric energy and
wherein the energy harvesting device (30) is coupled to a control system (20) of the turbo engine (100) as a redundant electric energy supply and / or the at least one kinetic energy converter (40) providing a means for reducing the vibrational energy of the turbo engine (100).

2. Turbo engine according to claim 1, wherein the energy harvesting device (30) with the at least one thermoelectric device (10) and / or the at least one kinetic energy converter (40) is positioned at least partially on the core of the turbo engine (100), in particular around the compressor (101), the combustion chamber (102) and / or the turbine (103).

3. Turbo engine according to claim 1 or 2, wherein the at least one kinetic energy converter (40) comprises a magnetic device (41) which is coupled with a conducting element (42), so that a relative movement of the magnetic device (41) to the conducting element (42) introduces a voltage in the conducting element (42).

4. Turbo engine according to at least one of the preceding claims, wherein the at least one kinetic energy converter (40) comprises at least one piezoelectric element.

5. Turbo engine according to at least one of the preceding claims, wherein the energy harvesting device (30) is a layered structure with at least one thermoelectric device layer (31) and / or at least one kinetic converter layer (32).

6. Turbo engine according to claim 5, wherein the energy harvesting device (30) is at least partially a flexible structure to fit around round or complex shapes in the turbine engine (100).

7. Turbo engine according to at least one of the preceding claims, wherein the electric current coming from the at least one thermoelectric device (10) is converted into an alternating current or the current coming from the at least one kinetic energy converter (40) is converted into direct current.

8. Turbo engine according to at least one of the preceding claims, wherein the at least one thermoelectric device (10) and / or the at least one kinetic energy converter (40) is coupled to an electrical energy storage means, in particular a rechargeable battery and / or a capacitor.

9. Energy harvesting device for the use in a turbo engine, in particular a turbine for an airplane,
**characterized in that**
the energy harvesting device (30) comprises at least one thermoelectric device (10) for producing electric energy from temperature differences in the operating turbo device (100) and / or at least one kinetic energy converter (40) for the conversion of vibrational energy into electric energy and wherein the energy harvesting device (30) can be coupled to a control system (20) of the turbo device (100) as a redundant electric energy supply and / or the at least one kinetic energy converter (40) providing a means for reducing the vibrational energy of the turbo engine (100).

10. Energy harvesting device according to claim 9, with a layered structure with at least one thermoelectric device layer (31) and / or at least one kinetic converter layer (32).

11. Energy harvesting device according to claim 10, with a flexible structure to fit around round or complex shapes in the turbine engine (100).

12. Method for harvesting energy in a turbo engine, in particular a turbine for an airplane,
**characterized in that**
an energy harvesting device (30) comprising at least one thermoelectric device (10) producing electric energy from temperature differences in the turbo engine (100) and / or at least one kinetic energy converter device (40) generating electrical energy from vibrations in the turbo engine (100), the electrical energy being used as a redundant energy supply for a control system (20) of the turbine engine (100) and / or the at least one kinetic energy converter (40) providing a means for reducing the vibrational energy of the turbo engine (100).
